# EUROPEAN PATENT APPLICATION

(11) **EP 0 726 575 A2**
(43) Date of publication of application: **14.08.1996**
(21) Application number: 96300450.2
(22) Date of filing: 23.01.1996
(51) Int. Cl.: G11C 5/14

(54) **Semiconductor integrated circuit device**

(30) Priority: 10.02.1995 JP 22678/95
(71) Applicant: International Business Machines Corporation, Armonk, N.Y. 10504 (US)
(72) Inventor: Miyatake, Hisatada, Ohtsu-shi, Shiga-ken (JP); Sunaga, Toshio, Kusatsu-shi, Shiga-ken (JP); Kitamura, Koji, Kusatsu-shi, Shiga-ken (JP); Yamamoto, Masaaki, Moriyama-shi, Shiga-ken (JP)
(74) Representative: Williams, Julian David

(57) **Abstract**

A DRAM macro cell 14 integrated together with a logic cell on the same chip comprises a guard ring 26 surrounding the memory forming area, memory cell arrays 42, a power supply line 34, a ground line 36, additional ground lines 38, and by-pass capacitors 70 connected between the power supply line 34 and the ground line 36. The power supply line 34 is connected to a power supply pad different from the power supply pad to which the power supply line of the logic cell is connected, and the ground line 36 and the ground line of the logic cell are connected to common ground pads or proximate grounding pads interconnected by low-impedance lines. The additional ground lines 38 are connected to the substrate to stabilize substrate potential. This provides a high-density semiconductor integrated circuit device which is reliable and enables high-speed operation by forming DRAM macro cells and logic cell on the same chip.

## Description

The present invention relates to a semiconductor integrated circuit device.

With recent decrease in size and increase in speed of computer systems, increase in speed of DRAMs has also been demanded.

Increase in the speed of a DRAM has two aspects: the reduction of access time, that is, the reduction of time from the receipt of request for data to the transmission of the data; and the reduction of cycle time, that is, increase in the amount of data transferred in a unit time.

As the access time of DRAMs is reduced, delay of data transfer through connection lines on a card (board) connecting DRAM chips and logic chips becomes non-ignorable when the entire system is considered.

In order to increase the data transfer rate, it is effective to increase the width of a data bus. However, since conventional memory modules are formed separately from logic chips, and these memory modules and logic chips are mounted on a card, the width of the data bus is limited by the card area used for wiring and module mounting.

If the wiring load on a card is quickly switched, power consumption increases, and large noise is generated by simultaneous switching. Such noise may cause problems such as EMC. The noise problem caused by simultaneous switching becomes more serious as the width of the data bus on a card increases.

In an ASIC (application specific integrated circuit) which is one of LSI types, desired functions are usually realized by accessing required ones from already designed blocks registered in a computer library and placing the blocks on the same chip and by wiring between the blocks. For this, basic logic cells of a scale of several gates or less, and macro cells of a scale of several hundreds gates to several thousands gates are registered in the library. If DRAM macro cells are registered in this library and integrated on the same chip together with logic cells and analog cells, most of the above problems may be solved.

However, when a logic block contains multi-bit counters or registers, a current in the power supply line or ground line of a chip may suddenly vary if these counters or registers switch simultaneously, or if off-chip drivers for supplying signals to external peripheral circuits outside the chip switch simultaneously. As a result, the junction between the diffusion region connected to the power supply line or ground line and the semiconductor substrate or well may be forward-biased to cause minority carriers to be injected into the diffusion region. This may cause the problem of latch-up. On the other hand, a DRAM memory cell contains a capacitor, and one of the plate electrodes of the capacitor is often constituted by the diffusion region formed in the surface of the substrate. If minority carriers are injected into the diffusion region of the capacitor, the memory content stored in the capacitor may change. Also, since capacitors are also used in dynamic circuits in the DRAM block or macro cell, there may happen the case where the dynamic circuits erroneously operate. The problem of the minority carrier injection becomes more serious when a DRAM block is mixed with a logic block on the same chip. Also, noise generated by DRAM and logic blocks may cause another problem. Since a DRAM requires a large current at the time of sense amplification and bit line precharge, relatively large noise is induced in the power supply line or ground line at these timings. On the other hand, as stated above, a logic block may produce a large noise when circuits such as counters switch simultaneously. If such noise is coupled to the bit line (data line) connected to each memory cell, it may be superimposed on the cell signal voltage read out to the bit line, narrowing the operation margin and easily causing read errors. This problem becomes serious when a memory block is mixed with a logic block on the same chip.

In accordance with the present invention, there is now provided a semiconductor integrated circuit device in which a logic block and a memory block connected to the logic block are formed on a semiconductor substrate of the same chip with power supply pads, ground pads and signal pads being formed thereon, the device being characterised by: the memory block including an array of DRAM memory cells, a power supply line and a ground line, each of the memory cells including a memory capacitor; the logic block including a logic circuit, a power supply line, and a ground line; and the power supply line of the memory block and the power supply line of the logic block being connected to different power supply pads.

Viewing the present invention from another aspect, there is now provided a semiconductor integrated circuit device in which a logic block and a memory block connected to the logic block are formed on a semiconductor substrate of the same chip with power supply pads, ground pads and signal pads being formed thereon, the device being characterised by: the memory block including an array of a plurality of DRAM macro cells, each of the DRAM macro cells including one or more DRAM memory cell arrays, peripheral circuits required for read and write operations of the one or more DRAM memory arrays, a power supply line and a ground line, and the semiconductor substrate including a guard ring of the opposite conductivity type to that of the semiconductor substrate, the guard ring being formed to surround a region including the one or more DRAM memory cell arrays and the peripheral circuits of each of the DRAM macro cells.

Viewing the present invention from yet another aspect there is now provided a semiconductor integrated circuit device in which a logic block and a memory block connected to said logic block are formed on a semiconductor substrate of the same chip with power supply pads, ground pads and signal pads being formed thereon, the improvement comprising: said memory block including an array of a plurality of DRAM macro cells, each of said DRAM macro cells including one or more DRAM memory cell arrays, peripheral circuits required for read and write operations of said DRAM memory cell arrays, a power supply line and a grounding line, said logic block including a logic circuit, a power supply line and a ground line; and said power supply line and said ground line of each of said DRAM macro cells being formed in the shape of a frame to surround a region including said one or more memory cell arrays and said peripheral circuits of the DRAM macro cell.

Viewing the present invention from a further aspect, there is now provided a semiconductor integrated circuit device in which a logic block and a memory block connected to said logic block are formed on a semiconductor substrate of the same chip with power supply pads, ground pads and signal pads being formed thereon, the improvement comprising: said memory block including an array of a plurality of DRAM macro cells, each of said DRAM macro cells including one or more DRAM memory cell arrays, peripheral circuits required for read and write operations of said DRAM memory arrays, a power supply line and a ground line, said logic block including a logic circuit, a power supply line and a ground line; said power supply line of said DRAM macro cells and said power supply line of said logic block are respectively connected to different power supply pads, and said ground line of said DRAM macro cells and said ground line of said logic block are connected to the same ground pad or different ground pads which are close to each other and interconnected through a low impedance line.

Viewing the present invention from still a further aspect, there is now provided a semiconductor integrated circuit device in which a logic block, a memory block, a receiver circuit, and an off-chip driver circuit are formed on a semiconductor substrate of the same chip with power supply pads, ground pads and signal pads being formed thereon, the improvement comprising: said memory block including an array of a plurality of DRAM macro cells, each of said DRAM macro cells including one or more arrays of DRAM memory cells each cell comprising a field effect transistor and a capacitor, peripheral circuits required for read and write operations of said DRAM memory arrays, a power supply line and a ground line, said peripheral circuits including an address circuit, input/output data circuit, a clock and control signal generating circuit, a row address decoder circuit, a column address decoder circuit and a sense amplifier circuit, the improvement comprising: said logic block including a logic circuit, a power supply line and a ground line; said field effect transistor of each said DRAM memory cell being formed in a well of the opposite conductivity type to that of said semiconductor substrate, each of said DRAM macro cells including a guard ring of the opposite conductivity type to that of said semiconductor substrate, formed to surround a region including said one or more memory cell arrays and said peripheral circuits of the DRAM macro cell, said power supply line of said DRAM macro cells and said power supply line of said logic block are connected to different power supply pads, and said ground line of said DRAM macro cells and said ground line of said logic block are connected to the same ground pad or different ground pads which are close to each other and interconnected through a low impedance line.

Viewing the present invention from still another aspect, there is now provided a semiconductor integrated circuit device in which a logic block, a memory block, a receiver circuit, and an off-chip driver circuit are formed on a P-type semiconductor substrate of the same chip with power supply pads, ground pads and signal pads being formed thereon, the improvement comprising: said memory block including an array of a plurality of DRAM macro cells; each of said DRAM macro cells including one or more arrays of DRAM memory cells each cell comprising a field effect transistor and a capacitor, peripheral circuits required for read and write operations of said DRAM memory arrays, a power supply line and a ground line, said peripheral circuits including an address circuit, input/output data circuit, a clock and control signal generating circuit, a row address decoder circuit, a column address decoder circuit and a sense amplifier circuit, said logic block including a logic circuit, a power supply line and a ground line; said field effect transistor of each said DRAM memory cell being formed in a well of N conductivity type; each of said DRAM macro cells including a guard ring of N conductivity type formed to surround a region including said one or more DRAM memory cell arrays and the peripheral circuits of the DRAM macro cell; said power supply line of each of said DRAM macro cells being formed in the shape of a frame to surround a region including said one or more DRAM memory cell arrays and said peripheral circuits of the DRAM macro cell and to positionally overlap with said guard ring, said power supply line being connected to said guard ring.

Viewing the present invention from another aspect, there is now provided a semiconductor integrated circuit device in which a logic block, a memory block, a receiver circuit and an off-chip driver circuit are formed on an N-type semiconductor substrate of the same chip with power supply pads, ground pads and signal pads being formed thereon, the improvement comprising: said memory block including an array of a plurality of DRAM macro cells; each of said DRAM macro cells including one or more arrays of DRAM memory cells each cell comprising a field effect transistor and a capacitor, peripheral circuits required for read and write operations of said DRAM memory arrays, a power supply line and a ground line, said peripheral circuits including an address circuit, input/output data circuit, a clock and control signal generating circuit, a row address decoder circuit, a column address decoder circuit and a sense amplifier circuit, said logic block including a logic circuit, a power supply line and a ground line; said field effect transistor of said DRAM memory cell being formed in a well of P conductivity type; each of said DRAM macro cells including a guard ring of P conductivity type formed to surround a region including said one or more DRAM memory cell array and said peripheral circuits of the DRAM macro cell; said ground line of each of said DRAM macro cells being formed in the shape of a frame to surround a region including said one or more DRAM memory cell arrays and said peripheral circuits of the DRAM macro cell and to positionally overlap with said guard ring, said ground line being connected to said guard ring.

The present invention thus advantageously provides a semiconductor integrated circuit device in which a DRAM memory block and a logic block are formed on the same chip in high density and operate stably at high speed.

In an embodiment of the present invention there is provided a semiconductor integrated circuit device which can improve the data transfer rate and the access time, can enhance the degree of freedom in configuration of DRAMs and design of interfaces, and can lower power consumption and noise.

In a preferred embodiment of the present invention there is provided a semiconductor integrated circuit device in which a logic block and a memory block connected to the logic block are formed on a semiconductor substrate of the same chip on which power supply pads, ground pads and signal pads are formed for external connections. The memory block includes a DRAM memory cell array in which DRAM cells containing memory capacitors are arranged, a power supply line and a ground line. The logic block includes a logic circuit, a power supply line and a ground line. The power supply line of the memory block and the power supply line of the logic block are connected to different power supply pads.

The ground line of the memory block and the ground line of the logic block are preferably connected to the same ground pad, or different ground pads which are close to each other and interconnected by a low impedance line.

The chip further includes an off-chip driver circuit having a power supply line and a ground line. The power supply line of the off-chip driver circuit is connected to a power supply pad different from the power supply pads to which the power supply lines of the memory block and the logic block are connected, and the ground line of the off-chip driver circuit is connected to the ground pad different from the ground pads to which the ground lines of the memory block and the logic block are connected.

The chip also includes a receiver circuit having a power supply line and a grounding line. The power supply line of the receiver circuit is connected to a power supply pad different from the power supply pads to which the power supply lines of the memory block and the logic block are connected, and the ground line of the receiver circuit is connected to the same ground pad to which the ground lines of the memory block and the logic block are connected, or different ground pads which are close to each other and interconnected by a low impedance line.

The memory block has an array of DRAM macro cells. Each DRAM macro cell includes one or more DRAM memory cell arrays and peripheral circuits required for read and write operations of the DRAM memory arrays. DRAM memory cells are formed in a well of the opposite conductivity type to that of the semiconductor substrate, and the region of DRAM memory cell arrays and peripheral circuits of each DRAM macro cell is surrounded by a guard ring of the opposite conductivity type to that of the semiconductor substrate.

The power supply line and ground line of each DRAM macro cell are formed in the shape of a frame to surround the region of the DRAM memory cell arrays and the peripheral circuits of each DRAM macro cell. If the semiconductor substrate is of P conductivity type, the guard ring is of N type, and the power supply line of each DRAM macro cell is formed in a frame shape so that it overlaps with the guard ring, and is connected to the guard ring. If the semiconductor substrate is of N type, the guard ring is of P type, and the ground line of each DRAM macro cell is formed in a frame shape so that it overlaps with the guard ring, and is connected to the guard ring.

Each DRAM macro cell may have an additional power supply line or ground line which is connected to a predetermined power supply pad or ground pad but not connected to the internal circuit of the memory block. The additional line may be connected to the semiconductor substrate at several locations to stabilize the electric potential of the semiconductor substrate.

An on-chip by-pass capacitor is connected between the power supply line and the ground line of each DRAM macro cell. It is preferred that the by-pass capacitor and the memory capacitor are trench-type capacitors.

Preferred embodiments of the present invention will now be described by way of example only referring to attached drawings, in which:
Figure 1 is a floor plan view showing the structure of a DRAM macro cell used in a semiconductor integrated circuit device as an ASIC according to the first embodiment of the present invention;
Figure 2 is a simplified block diagram of a DRAM macro cell of Figure 1;
Figure 3 is a chip layout diagram showing the structure of a semiconductor integrated circuit device as an ASIC according to the first embodiment of the present invention in which the DRAM macro cell of Figure 1 is used;
Figure 4 is a chip layout diagram showing the structure of a semiconductor integrated circuit device as an ASIC according to the second embodiment of the present invention in which the DRAM macro cell of Figure 1 is used;
Figure 5 is a chip layout diagram showing the structure of a semiconductor integrated circuit device as an ASIC according to the third embodiment of the present invention;
Figure 6 is a floor plan view showing the structure of a DRAM macro cell used in the semiconductor integrated circuit device of Figure 5; and
Figure 7 is a sectional view showing an example of a memory cell.

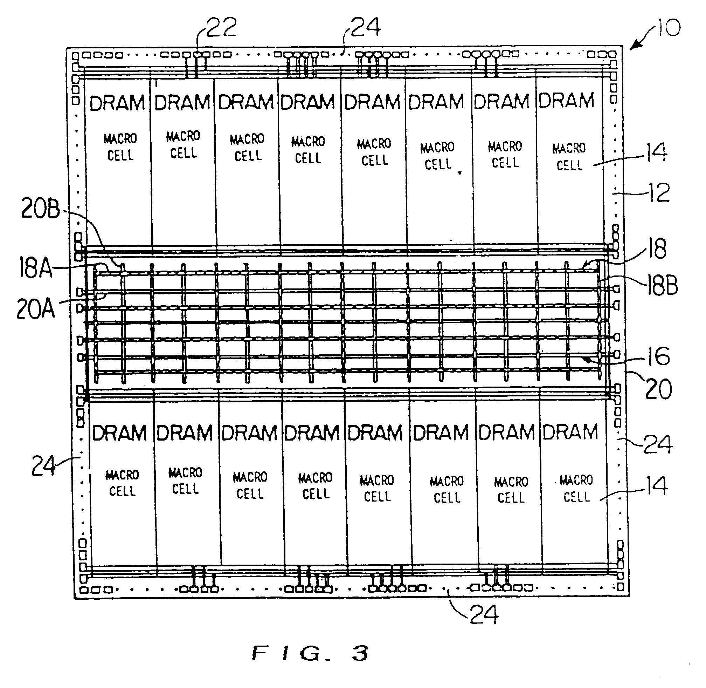

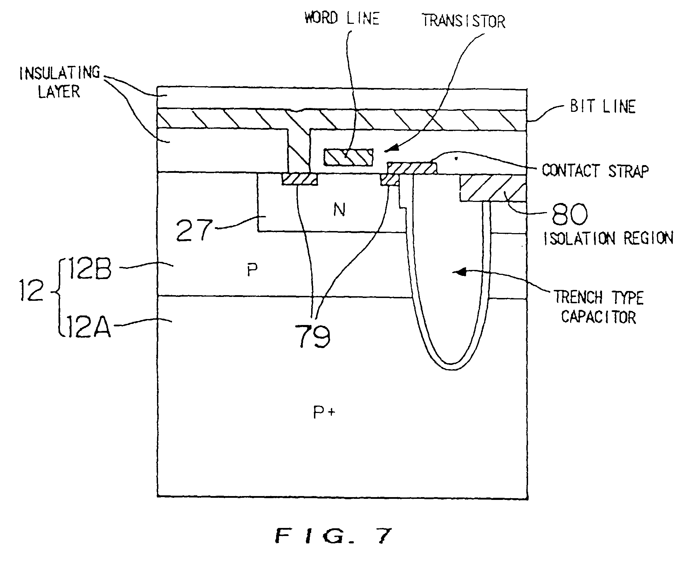

Figure 3 shows the structure of a semiconductor integrated circuit 10 as an ASIC according to the first embodiment of the present invention. The semiconductor integrated circuit 10 is formed in a single chip having a semiconductor substrate 12. As Figure 7 shows, the semiconductor substrate 12 is composed of an epitaxial wafer in which a P-type epitaxial layer 12B of a low impurity concentration formed on a P-type semiconductor substrate 12A of a high impurity concentration.

As Figure 3 shows, two rows of rectangular DRAM macro cells 14 of 32k × 9 bits per macro cell formed using the 4 Mb DRAM technology are arranged along opposite sides of the semiconductor substrate 12. Each row has eight DRAM macro cells 14.

Between arrays of DRAM macro cells 14 are formed a logic cell or block 16 having about 100 k gates. The logic cell 16 includes logic circuits (not shown), a power supply line 18 for supplying a power supply voltage to the logic circuits, and a ground line 20, located below the power supply line 18, for supplying a ground voltage to the logic circuits. The power supply line 18 consists of a plurality of long-side power supply line segments 18A along the long-side direction of the logic cell 16, and a plurality of short-side power supply line segments 18B along the short-side direction of the logic cell 16. Two long-side power supply line segments 18A located in the center are connected to respective power supply pads. Similarly, the ground line 20 consists of long-side ground line segments 20A placed between adjacent long-side power supply line segments 18A, and short-side ground line segments 20B placed between adjacent short-side power supply lines 18B. Two long-side ground line segments 20A located outside the long-side power supply lines 18A connected to the power supply pads are connected to ground pads.

A pad region 24 is formed in the peripheral portion of the semiconductor substrate 12. In the pad region 24, pads 22 including various power supply pads, ground pads, and signal I/O pads are formed. Also in the pad region 24, chip receiver circuits (not shown) for receiving signals from external peripheral circuits and off-chip driver circuits (not shown) for transmitting signals to external peripheral circuits are formed. In the pad region 24 are formed frame-shaped power supply lines (not shown) and ground lines (not shown) for the receiver circuits and the off-chip driver circuits.

DRAM macro cells 14 and logic block 16, and the chip receiver circuits and off-chip driver circuits are connected by internal wiring (not shown).

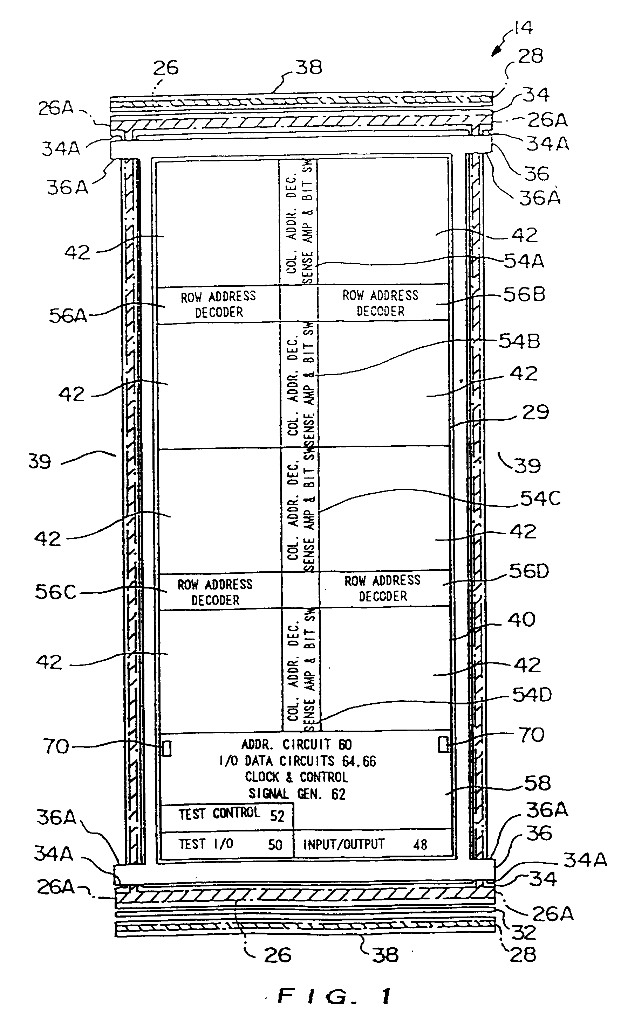

Figure 1 shows the structure of a DRAM macro cell 14 of the upper portion of the DRAM macro cell array shown in Figure 3. Each DRAM macro cell 14 includes in the substrate surface a guard ring 26 of the conductivity type (N-type in this embodiment) opposite to that of the semiconductor substrate 12. The guard ring 26 is formed in the shape of a frame so as to surround a memory forming region 29 including memory cell arrays 42 and peripheral circuits which will be described later. The guard ring 26 has extensions 26A at the corners along the short-side direction of the guard ring 26, which are to be interconnected with similar extensions of guard rings of adjacent macro cells.

On the guard ring 26, a power supply line (metal wiring) 34 for supplying a power supply voltage to internal circuits of the DRAM macro cell 14 is formed via an insulating layer (not shown) so as to positionally overlap with the guard ring 26. The power supply line 34 is formed in the shape of a frame corresponding to the guard ring 26 so as to surround the memory forming region 29. The power supply line 34 also has extensions 34A at the corners along the short-side direction of the power supply line 34.

A ground line (metal wiring) 36 for supplying a ground potential to internal circuits of the DRAM macro cell 14 is formed between the power supply line 34 and the memory forming region 29 via an insulating layer (not shown). The ground line 36 is also formed in the shape of a frame so as to surround the memory forming region 29. The ground line 36 has extensions 36A at the corners along the short-side direction of the ground line 36.

DRAM macro cells 14, logic block 16, receiver circuits, and off-chip driver circuits are designed to be operated by the same source voltage of 3.3 V or 5.0 V, and the ground voltage is, for example, 0 V.

Also, the DRAM macro cell 14 has upper and lower P+type substrate contact regions (diffusion regions) 28 extending along the short-side direction of the DRAM macro cell 14. On the substrate contact region 28, additional ground lines 38 overlapping with the substrate contact region 28 are formed via insulating layers (not shown). These ground lines 38 are connected to ground pads provided on the peripheral portion of the chip, but not connected to circuits within the chip, and connected to the substrate contact region 28 at a plurality of locations.

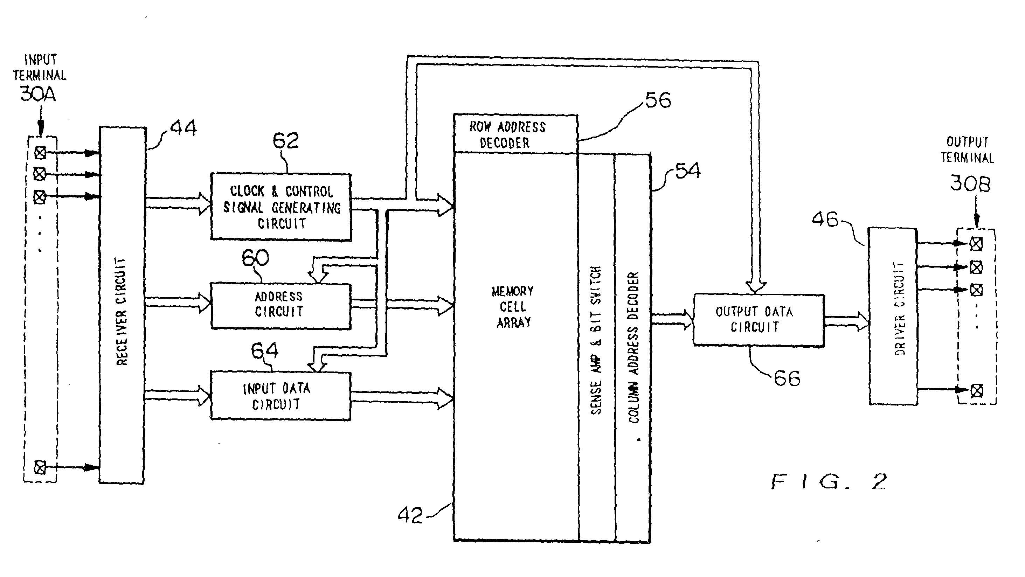

The region between the lower short-side portion of the power supply line 34 and ground line 38 is used as a terminal region 32. In the terminal region 32, terminals 30 (input terminals 30A and output terminals 30B in Figure 2) used for interconnecting the internal wiring of the DRAM macro cell 14 and the wiring of the logic cell 16, receiver circuits and off-chip driver circuits are formed.

When an array of DRAM macro cells 14 is formed by arranging a plurality of DRAM macro cells 14, the extensions 34A of the power supply line 34, the extensions 36A of the ground line 36, and the extensions 26A of the guard ring 26 along the short-side direction of each DRAM macro cell 14, the substrate contact regions 28, and the ground lines 38 are interconnected with corresponding ones of adjacent macro cells to form the continuous wiring or region.

In the DRAM macro cell array, the region between adjacent DRAM macro cells 14 is used as a wiring region 39 for passing the wiring from and to the logic cell 16.

The power supply line 34 and ground line 36 are connected to the internal power supply lines and internal grounding lines (not shown) provided in the DRAM macro cell 14, so as to supply power supply voltage and ground voltage to the internal circuits of the DRAM macro cell 14, respectively.

It is preferable that the power supply line 34 of the DRAM macro cell 14 and the power supply line 18 of the logic cell 16 are connected to different power supply pads on the chip. In typical examples, the pads 22 on the chip are connected to leads on a chip carrier (not shown) using wire bonding or C4 bonding using solder balls, and the leads of the chip carrier are in turn connected to the power supply bus, ground bus, and signal lines on a card (not shown). However, as wiring density increases, the size of connections or bonds become smaller, providing non-ignorable parasitic impedance between the chip and the card. With increase in circuit density, the circuit is susceptible to noise. Especially, when a very sensitive DRAM is packaged together with a logic block, they should be electrically isolated from each other.

If the power supply line 34 of the DRAM macro cell 14 and the power supply line 18 of the logic cell 16 are connected to the same power supply pad, parasitic impedance between this pad and the power supply bus on the card acts as a common impedance, and the operation of one cell will easily affect the operation of the other cell. By connecting the power supply line 34 of the DRAM macro cell 14 and the power supply line 18 of the logic cell 16 to different power supply pads, such a common parasitic impedance can be reduced, and highly reliable operations can be achieved. When common parasitic impedance is small, or when an on-chip by-pass capacitor of large capacitance can be formed between the power supply line 18 and ground line 20 of the logic cell 16, the power supply line 34 of the DRAM macro cell 14 and the power supply line 18 of the logic cell 16 may be connected to the same power supply pad, but it is generally preferable to connect these power supply lines to different power supply pads.

It is preferable that the ground line 36 of the DRAM macro cell 14 and the ground line 20 of the logic cell 16 are connected to a common ground pad on the chip, or to different ground pads which are located close to each other and interconnected through a low impedance line. By this, difference in signal reference levels between the DRAM macro cells 14 and the logic cell 16 may practically be eliminated, minimizing the effect of noise and preventing erroneous operation. Although it is preferable to connect the ground line 36 of the DRAM macro cell 14 and the ground line 20 of the logic cell 16 to a common ground pad, if the connection length between these ground lines and the common ground pad becomes long, these ground lines may be connected to different ground pads, which are connected by a low-impedance interconnection line on the chip. In this case, however, proximate pads should be used to avoid the effect of the impedance of the interconnection line.

It is preferable that the additional ground lines 38 are connected to the same ground pad to which the ground line of the DRAM macro cell 14 is connected, in order to maintain the potential of the substrate 14 constant.

Since the off-chip driver circuit has possibility to generate large noise, it is preferable that the power supply line of the off-chip driver circuit is connected to a power supply pad different from the pads to which the power supply line 34 of the DRAM macro cell 14 and the power supply line 18 of the logic cell 16 are connected. However, when a large on-chip by-pass capacitor can be connected between the power supply line 18 and ground line 20 of the logic cell 16, the power supply line of the off-chip driver circuit and the power supply line 18 of the logic cell 16 may be formed as a single continuous common power supply line to reduce the impedance of these power supply lines.

Since the ground line of the off-chip driver circuit may produce a large noise, it is preferable that the ground line of the off-chip driver circuit is connected to a ground pad different from the pads to which the ground line 36 of the DRAM macro cell 14 and the ground line 20 of the logic cell 16 are connected.

Since the power supply line of the chip receiver circuit may also generate noise, it is preferable that the power supply line of the chip receiver circuit is connected to a power supply pad different from the pads to which the power supply line 34 of the DRAM macro cell 14, the power supply line 18 of the logic cell 16, and the power supply line of the off-chip-driver circuit are connected.

Although it is preferable that the ground line of the chip receiver circuit is connected to the same ground pad to which the ground line 20 of the logic cell 16 is connected so as to minimize the effect of the off-chip driver and to have the same signal reference level as the logic cell 16, these lines may be connected to different pads which are closely located and interconnected by a low impedance line.

These power supply lines and ground lines of the DRAM macro cell 14, the logic cell 16, the receiver circuit, and off-chip driver circuit should be formed by a low impedance metal wiring.

In the memory cell array forming region 40 within the guard ring 26, eight memory cell arrays 42 (4k × 9 bits) arranged in 2 × 4 are formed. A memory cell consists of a memory capacitor composed of a trench-type capacitor as shown in Figure 7, and a P-channel type field effect transistor which is a switching element. Each subarray of each memory cell array 42 has an N-type well 27 (Figure 7), and the field effect transistor is formed in the well 27. A word line (not shown) for selection in the row direction and a bit line (not shown) for selection in the column direction are connected to each memory cell in the memory cell array 42.

In the lower region of the DRAM macro cell 14 is formed an I/O circuit 48 including a memory receiver circuit 44 (Figure 2) for receiving signals from the logic cell 16 or the chip receiver circuit via the terminals 30 formed in the terminal region 32, and a memory driver circuit 46 (Figure 2) for transmitting signals to the logic cell 16 or the off-chip driver circuit. In the lower region of the DRAM macro cell 14 are also formed a test I/O circuit 50 for receiving and transmitting memory test signals between the logic cell 16, the chip receiver circuit or the off-chip driver circuit and DRAM macro cell 14 via the terminals 30; and a test control circuit 52 for switching between the I/O circuit 48 and the test I/O circuit 50, selecting the memory cell array 42 that is to be tested, and switching the test mode of the memory cell array 42.

In the regions 54 (from 54A to 54D) between laterally adjacent memory cell arrays 42, a column address decoder circuit for selecting bit lines, a bit switch circuit for connecting bit lines and data lines, and a sense amplifier circuit are formed. In the region 56 (from 56A to 56D) between each vertically arranged pair of memory cell arrays 42, a row address decoder circuit for selecting word lines are formed. Thus, the row address decoder is shared by two vertically adjacent memory cell arrays 42, and the column address decoder is shared by two horizontally adjacent memory arrays 42. Figure 2 shows the memory configuration of the DRAM macro cell of Figure 1. Note that Figure 2 is shown in simplified form in that the row and column address decoders are not shared by two arrays.

In the region 58 of Figure 1, circuits corresponding to the address circuit 60, the clock and control signal generating circuit 62, the input data circuit 64, and the output data circuit 66 are formed. The address circuit 60 includes an address predecoder, receives address signals from the I/O circuit 48, selects the memory cell array 42 to be used, and transmits row address to the row decoder and column address to the column decoder corresponding to the selected memory array 42. The clock and control signal generating circuit 62 generates clock signals (timing signals) and control signals required by circuits within the DRAM macro cell 14 in response to signals from the I/O circuit 48. The input data circuit 64 includes a data steering buffer for temporarily storing input data from the memory receiver circuit 44 (Figure 2), and transmits input data to the memory cell array 42. The output data circuit 66 includes a data steering buffer for temporarily storing output data from the sense amplifier, and outputs data to the memory driver circuit 46 in response to control signals from the clock and control signal generating circuit 62. At the two corners of this region 58, by-pass capacitors 70 which are trench-type capacitors such as shown in Figure 7, connected between the power supply line 34 and the ground line 36 are formed.

When a memory cell in each DRAM macro cell 14 is accessed, a part of the row address bits is used for the selection of the memory cell array 42. More specifically, each row address has 10 bits and column address has 5 bits, and 2 bits of the row address are used for the selection of the memory cell arrays 42. By this, two memory cell arrays 42 adjacent to the row address decoder are selected, and the word lines in the selected memory cell arrays 42 are selected.

The DRAM macro cell 14 has the by-pass capacitor 70 connected between the power supply line 34 and the ground line 36. Therefore, when a rush current flows between these lines, the effect of this current on the DRAM macro cell 14 or the logic cell 16 may be minimized. Since this by-pass capacitor 70 may be formed utilizing a vacant space on the semiconductor substrate 12, sufficient capacitance may be obtained without increasing the size of the DRAM macro cell 14. The structure of the by-pass capacitor 70 may be the same as the structure of the memory capacitors, and since the by-pass capacitor 70 may be formed in the same process as the memory capacitors, the number of process steps is not increased.

Since the semiconductor substrate 12 comprises an epitaxial layer of a lower impurity concentration formed on a substrate of a higher impurity concentration, the noise current is removed to the lower side of the semiconductor substrate 12, carriers generated disappear in the high-impurity-concentration area of the semiconductor substrate 12, and increase in junction capacitance and decrease in junction break-down voltage are prevented. When CMOS devices are used in the DRAM macro cell 14 or the logic cell 16, the base resistance of the parasitic bipolar transistor is lowered, and latchup is prevented.

Since a trench-type capacitor is used as the memory capacitor, the storage capacitance of the memory cell is large and the inversion of stored contents or the erroneous operation of the memory cell due to the injection of minority carriers or the injection of noise carriers by α-particles are minimized. Furthermore, since the trench-type capacitor is suitable for planarization, fine pitch wiring in metal layers are easily achieved in the manufacture of the semiconductor integrated circuit device 10.

Since the memory cell is formed in the well 27 surrounded by the guard ring 26, and the guard ring 26 and the well 27 absorb noise carriers, the inversion of stored contents and the erroneous operation of the memory cell and the peripheral circuits of the DRAM macro cell 14 are prevented.

Since the semiconductor integrated circuit device 10 according to the first embodiment comprises DRAM macro cells 14 and logic cell 16 integrated on the same semiconductor substrate 12, and DRAM macro cells 14 and logic cells 16 are connected by multi-layer wiring, data bus width may be increased (144 bits (9 bits × 16)), and the data transfer rate may be increased. Since the length of wiring connecting the DRAM macro cell 14 and logic cell 16 can be reduced, the delay of signal transfer on the wiring may be reduced, and the access time and cycle time seen from the logic cell 16 may be shortened. The cycle time may be further shortened because the access time is shortened and precharging may be initiated at an earlier time. For example, the access time, cycle time, and data transfer rate of the DRAM macro cell 14 of the semiconductor integrated circuit device 10 according to this embodiment of the present invention are compared with those of conventional DRAMs as follows: in DRAMs used in conventional personal computers of a data bus width of 32 bits in which DRAM chip and logic chip are interconnected by wiring on a card, the cycle time is about 100 ns to about 180 ns, the access time is 60 ns, and the data transfer rate is about 22 MB/s to about 40 MB/s. on the other hand, in the semiconductor integrated circuit device 10 according to the first embodiment, the cycle time is 60 ns (30 ns when the page mode is used), the access time is 30 ns, and the data transfer rate is 300 MB/s.

In this semiconductor integrated circuit device 10, since DRAM macro cells 14 and logic cell 16 are integrated on the same semiconductor substrate 12, the size of the package and the number of address signal lines on the card are not required to be considered, and the address signals need not to be multiplexed, a large freedom in the design of DRAM macro cells 14 and logic cell 16 is obtained.

In the above semiconductor integrated circuit device 10, since the length of wiring connecting DRAM macro cells 14 and logic cell 16 may be shortened, power consumption and noise may be reduced. In a semiconductor integrated circuit package in which DRAM chips and logic chips are connected by wiring on a card, when 32 data lines each having a load capacitance of 50 pF are present on the card, which are driven in a 30 ns cycle (page mode and interleave), and switched between 0V and 5.0V every cycle, electric power required for charging and discharging these data lines is about 670 mW. On the other hand, in the semiconductor integrated circuit device 10, the load capacitance for a data line is at largest about 2 pF, and when 144 data lines are present, which are driven in a 30 ns cycle (page mode and interleave), and switched between 0V and 5.0V every cycle, electric power required for charging and discharging these data lines is about 120 mW. This difference appears as the difference in power consumption of the entire system, and this difference in power consumption of the entire system increases in proportion to the data transfer rate and the data bus width. Thus, compared to the case where a conventional type of semiconductor integrated circuit package is used in the system, the power consumption is greatly reduced when the present integrated circuit device 10 is used.

Among noise generated by data lines, noise caused by simultaneous switching is important. This noise is generated in proportion to the change rate in current flowing in the data line according to signal and in proportion to the inductance of the data line charged and discharged. Although the signal transient time and the inductance do not differ significantly between wiring on the card and wiring in the chip, the charging and discharging current increases in proportion to the load capacitance. Therefore, compared to a conventional type of semiconductor integrated circuit device, since the semiconductor integrated circuit device 10 according to the first embodiment has a small load capacitance for a data line, noise may be reduced to a large extent. Specifically, in the above example used in the description of power consumption, it is assumed that the discharging time of the data line on the card, the discharging time of the data line on the chip, the inductance of the ground line on the card and the inductance of the ground line on the chip for four DRAM macro cells are 10 ns, 4 ns, 5 nH, and 2 nH, respectively, that the peak current is twice the average current, and that the current reaches the maximum at the middle point of transition. Under these conditions, the peak value of noise voltage on the card reaches 3.2 V, while the peak value of noise voltage on the chip 10 is about 0.36 V. Also, since noise generated may be reduced greatly, unnecessary radiation (radiation noise) may be reduced to a large extent.

When the above semiconductor integrated circuit device 10 is manufactured, it is important that the integration of the manufacturing process of DRAMs and the manufacturing process of logic LSIs should be pursued to allow multi-layer fine-pitch wiring through the planarization of the entire semiconductor integrated circuit device.

In this embodiment, a trench-type capacitor suitable for planarization may be used as the memory capacitor and the by-pass capacitor 70, whereby planarization is achieved.

Also in this embodiment, since the oxide isolation region 80 (Figure 7) for isolating individual circuit elements of the DRAM macro cell 14 and the logic cell 16 is recessed to be in the same level as the semiconductor substrate, the unevenness of the semiconductor substrate 12 is minimized.

In order to remove the unevenness produced in the wiring layer (metal wiring), the insulating interlayer may be planarized by, for example, chemical mechanical polishing.

In this case, through holes or contact vias are formed in the planarized insulating layer, and filled with a stud conductor as by plating for connecting between wiring layers. Since the conductor is buried in through holes, the wiring layer is planarized, thus enabling multi-layer fine pitch wiring.

As described above, by using the trench-type capacitors as the memory capacitor and the by-pass capacitor 70, by using the recessed isolation region 80, and by burying the stud conductor in the planarized insulating interlayer, the unevenness of the device surface is reduced, preventing breaking of wiring and enabling multi-layer fine pitch wiring.

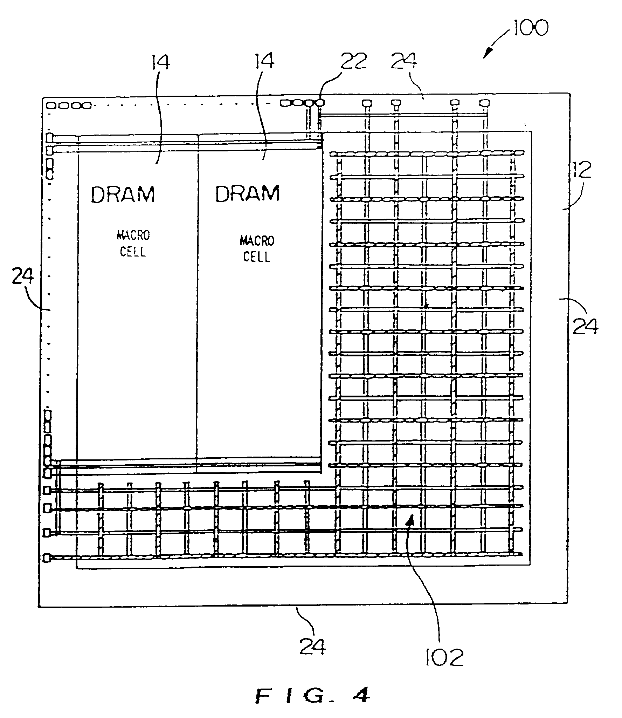

Figure 4 shows the structure of a one-chip semiconductor integrated circuit device 100 as an ASIC according to the second embodiment of the present invention. In the following description, the same symbols are used for the same components as in the first embodiment, and the description of these components will be omitted.

Two DRAM macro cells 14 are formed on the semiconductor substrate 12 of this semiconductor integrated circuit device 100. The logic cell or block 102 are formed in the area adjacent to the DRAM macro cells 14.

The configuration of the DRAM macro cells 14, the logic cell 102, the chip receiver circuit and the off-chip driver circuit, and the connection of the power supply lines and ground lines are the same as those described referring to Figures 1-3.

The above semiconductor integrated circuit 100 has the same effect as the semiconductor integrated circuit 10 according to the first embodiment, and the data bus width is 18 bits (9 bits × 2).

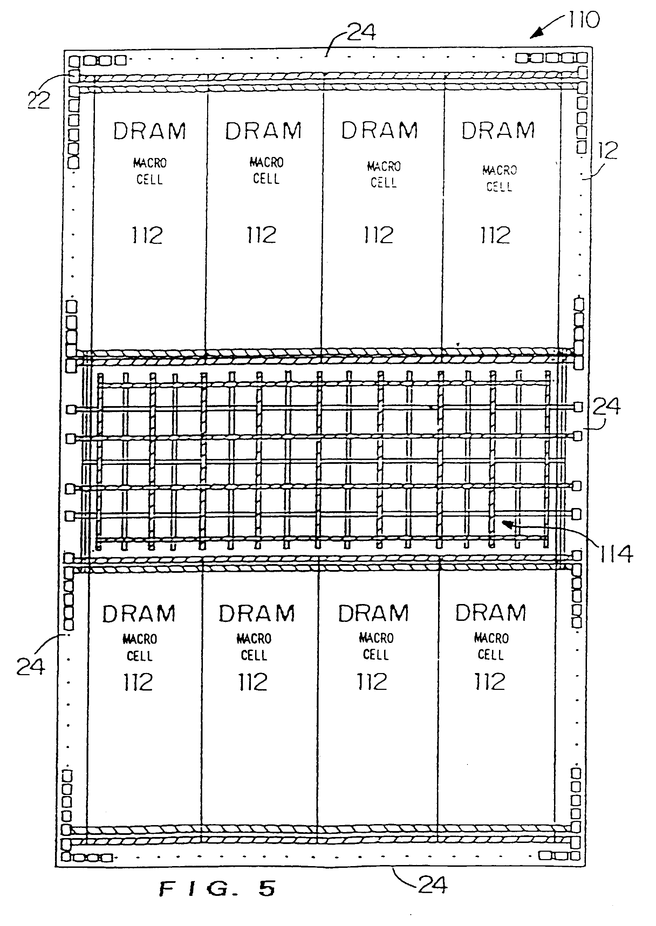

Figure 5 shows the structure of a one-chip semiconductor integrated circuit device 110 as an ASIC according to the third embodiment of the present invention.

On the semiconductor substrate 12 of this semiconductor integrated circuit device 110, two rows of four rectangular DRAM macro cells 112 of 64k × 18 bit-structure using the 16 Mb DRAM technology are formed in the semiconductor substrate 12. A logic cell or block 114 having about 200k gates is formed between the rows of DRAM macro cells 112.

In the logic cell 114, logic circuits (not shown), a power supply line (not shown) for supplying power supply voltage to the logic circuits, and ground line (not shown) for supplying ground voltage to the logic circuits is formed.

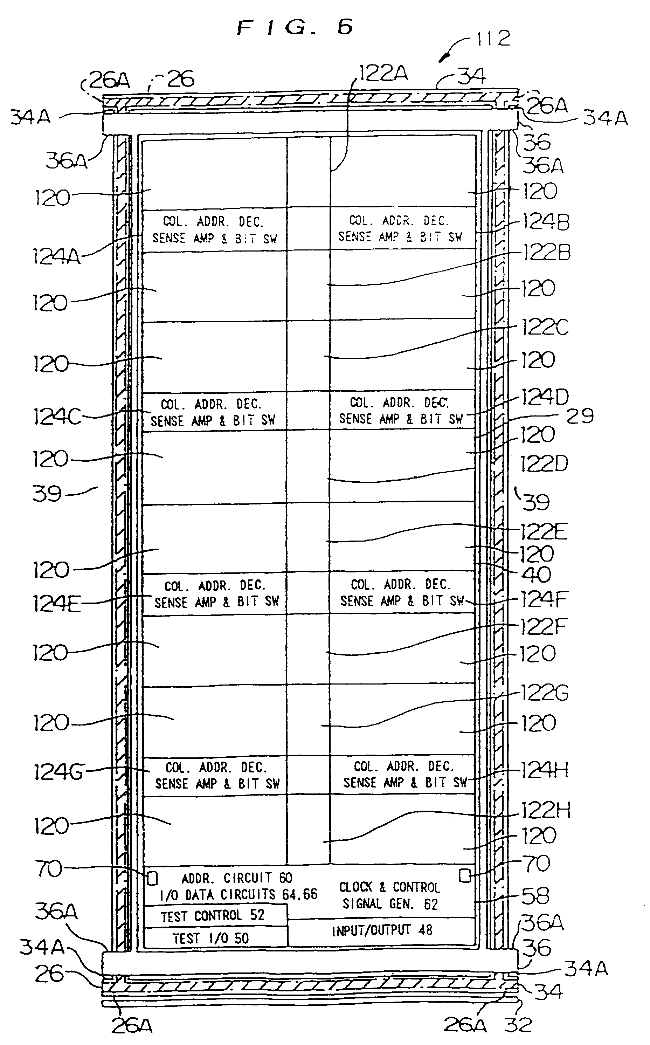

Figure 6 shows the structure of a DRAM macro cell 112. In the memory array forming region 40 of this DRAM macro cell 112, 2 × 8 memory cell arrays 120 (8k × 9 bits) consisting of trench-type capacitors and field effect transistors are arranged.

In the regions 122 (122A to 122H) between laterally adjacent memory cell arrays 120, row address decoders are formed. Furthermore, in the regions 124 (124A to 124H) between vertically adjacent pair of memory cell arrays 120, column address decoders, bit switches, and sense amplifiers are formed.

In this DRAM macro cell 112, the region corresponding to the substrate contact regions 28 of Figure 1 and additional ground lines corresponding to the ground lines 38 of Figure 1 are not formed.

Except for these difference, the structure of Figure 6 is the same as the structure of Figure 1.

In this DRAM macro cell 112, each row address has 11 bits, and each column address has 5 bits, and 3 bits of the row address is used for the selection of the memory cell array 120.

The configuration of the DRAM macro cells 112, the logic cell 114, the chip receiver circuit, and the off-chip driver circuit, and the connection of the power supply lines and ground lines are the same as those described referring to Figures 1-3.

The above semiconductor integrated circuit 110 has the same effect as the semiconductor integrated circuit 10 according to the first embodiment, and the data bus width is 144 bits (18 bits × 8).

In the embodiments described above, although a trench-type capacitor is used as the capacitor suited for planarization, a planer-type capacitor or a stack-type capacitor with improved planarization may be used as the memory cell capacitor and the by-pass capacitor.

For the logic cells of the above embodiments, logic cells for ASICs such as a standard cell, a macro cell and a gate array, and logic cells of full-custom design may be used, and various chip interfaces may be constructed as required. The logic cells may include not only digital circuits but also analog circuits.

Furthermore, in order to stabilize the substrate potential, the back side of the chip on which no circuit elements are formed may be connected to power supply, ground, or other potential, by means of an eutectic alloy, solder, or conductive adhesives.

In the above embodiments, the grounding lines 38, which are connected to ground pads but not connected to the internal circuit of the DRAM macro cell, are connected to the P-type semiconductor substrate. However, when an N-type semiconductor substrate is used, additional power supply lines, which are connected to power supply pads but not connected to the internal circuit, are provided and connected to the semiconductor substrate 12 at several locations.

Furthermore, to prevent soft error, some measures can be taken, for example, the formation of memory cell arrays in the well, the use of a trench-type capacitor in which a memory node is formed inside the trench and noise carriers are difficult to be injected as in the above embodiments, the use of a structure in which noise carriers are difficult to be injected into the memory node or bit lines, that is, a structure in which the size of the diffusion regions for the memory node and the bit lines (diffusion regions 79 of Figure 7) is decreased (the junction area is decreased), the selection of a material including less radioactive elements as the molding material of the package, or the coating of the chip surface with an organic material.

According to the present invention, the power supply line of the memory block and the power supply line of the logic block are formed separately and connected to different power supply pads, while the ground line of the memory block and the ground line of the logic block are formed separately and connected to a common ground pad or to proximate different ground pads interconnected by a low impedance line. Therefore, the common impedance between the memory block and the logic block may be reduced significantly, thereby minimizing influence of one block on the other block, and especially, the coupling of power supply noise may be reduced.

Also, according to the present invention, since the ground line of the memory block and the ground line of the logic block are connected to a common pad or proximate different ground pads interconnected by a low impedance line, difference in signal reference levels for the memory block and the logic block may be reduced, and error generated in receiving and transmitting signals between the memory block and the logic block may be reduced.

Furthermore, according to the present invention, since a by-pass capacitor is used between the power supply line and ground line of each DRAM macro cell, the effect of rush current may be minimized.

Also, since each DRAM macro cell region is surrounded by a guard ring, which absorbs minority carriers and noise carriers generated by α-particles, the inversion of memory contents and the erroneous operation of peripheral circuits of DRAM macro cell are prevented.

Since the power supply line and ground line of each DRAM macro cell are provided in a frame shape to surround the DRAM memory cell array and peripheral circuits of the DRAM macro cell, the internal circuit of the DRAM macro cell may access the power supply line and ground line in any direction at a minimum distance, and therefore, impedance of power supply connection and ground connection may be reduced, and flexibility in the design of wiring may be increased.

Since the guard ring and the power supply line or ground line to be connected to the guard ring are formed in a frame shape, so as to positionally overlap with each other, the guard ring and the power supply line or ground line may be connected at several locations, and the potential of the guard ring may be maintained constant.

By providing the additional power supply lines or ground lines, which are connected to power supply pads or ground pads but not connected to the internal circuit of the DRAM macro cell, and connected to the semiconductor substrate at several locations, the entire semiconductor substrate may be maintained at a constant potential.

According to the present invention, the memory block may be operated stably even if a memory block and a logic block are packaged on the same chip, thereby the data transfer rate may be increased and the access time may be shortened, the freedom of the structure of DRAMs and the design of interfaces may be improved, and power consumption and noise may be minimized.

## Claims

1. A semiconductor integrated circuit device in which a logic block and a memory block connected to the logic block are formed on a semiconductor substrate of the same chip with power supply pads, ground pads and signal pads being formed thereon, the device being characterised by:
the memory block including an array of DRAM memory cells, a power supply line and a ground line, each of the memory cells including a memory capacitor;
the logic block including a logic circuit, a power supply line, and a ground line; and
the power supply line of the memory block and the power supply line of the logic block being connected to different power supply pads.

2. The semiconductor integrated circuit device according to Claim 1, wherein the ground line of the memory block and the ground line of the logic block are connected to the same ground pad or different ground pads which are close to each other and interconnected through a low impedance line.

3. The semiconductor integrated circuit device according to Claims 1 or 2, wherein the chip includes an off-chip driver circuit provided with a power supply line and a ground line, and the power supply line of the off-chip driver circuit is connected to a power supply pad different from the power supply pad to which the power supply lines of the memory block and the logic block are connected.

4. The semiconductor integrated circuit device according to Claims 1 or 2, wherein the chip includes an off-chip driver circuit provided with a power supply line and a ground line, and the ground line of the off-chip driver circuit is connected to a ground pad different from the ground pad to which the ground lines of the memory block and the logic block are connected.

5. The semiconductor integrated circuit device according to Claims 1 or 2, wherein the chip includes a receiver circuit provided with a power supply line and a ground line, and the power supply line of the receiver circuit is connected to a power supply pad different from the power supply pad to which the power supply lines of the memory block and the logic block are connected.

6. The semiconductor integrated circuit device according to Claims 1 or 2, wherein the chip includes a receiver circuit provided with a power supply line and a ground line, and the ground line of the receiver circuit is connected to the same ground pad to which the ground line of the logic block is connected or different ground pads which are close to each other and interconnected through a low impedance line.

7. The semiconductor integrated circuit device according to Claims 1 or 2, wherein the chip includes an additional power supply line or ground line connected to a predetermined power supply pad or ground pad but not connected to the internal circuit of the memory block, and the additional power supply line or ground line is connected to the semiconductor substrate at a plurality of locations to stabilize the electric potential of the semiconductor substrate.

8. A semiconductor integrated circuit device in which a logic block and a memory block connected to the logic block are formed on a semiconductor substrate of the same chip with power supply pads, ground pads and signal pads being formed thereon, the device being characterised by:
the memory block including an array of a plurality of DRAM macro cells,
each of the DRAM macro cells including one or more DRAM memory cell arrays, peripheral circuits required for read and write operations of the one or more DRAM memory arrays, a power supply line and a ground line, and
the semiconductor substrate including a guard ring of the opposite conductivity type to that of the semiconductor substrate, the guard ring being formed to surround a region including the one or more DRAM memory cell arrays and the peripheral circuits of each of the DRAM macro cells.

9. The semiconductor integrated circuit device according to Claim 8, wherein the semiconductor substrate is of P conductivity type, the guard ring is of N conductivity type, and the power supply line of each of the DRAM macro cells is formed in the shape of a frame to surround a region including the one or more DRAM memory cell arrays and the peripheral circuits of the DRAM macro cell and to positionally overlap with the guard ring, the power supply line being connected to the guard ring.

10. The semiconductor integrated circuit device according to Claim 8, wherein the semiconductor substrate is of N conductivity type, the guard ring is of P conductivity type, and the ground line of each of the DRAM macro cells is formed in the shape of a frame to surround a region including the one or more DRAM memory cell arrays and the peripheral circuits of the DRAM macro cell and to positionally overlap with the guard ring, the ground line being connected to the guard ring.

11. The semiconductor integrated circuit device according to either one of Claims 8, 9, and 10, wherein the memory cell comprises a field effect transistor and a capacitor, and the field effect transistor is formed in a well of the opposite conductivity type to that of the semiconductor substrate.

12. The semiconductor integrated circuit device according to Claim 11, wherein each of the DRAM macro cells includes a by-pass capacitor connected between the power supply line and the ground line of the DRAM macro cell.

13. The semiconductor integrated circuit device according to Claim 12, wherein the capacitor of the memory cell and the by-pass capacitor are trench-type capacitors.
